Europäisches Patentamt

European Patent Office

Office européen des brevets

(11) Publication number: **0 072 603**
**B1**

**EUROPEAN PATENT SPECIFICATION**

(45) Date of publication of patent specification: **01.10.86**

(21) Application number: **82201230.8**

(22) Date of filing: **12.06.79**

(60) Publication number of the earlier application in accordance with Art. 76 EPC: **0 006 706**

(51) Int. Cl.⁴: **H 01 L 21/28,** **H 01 L 21/314,** **H 01 L 21/318, H 01 L 29/62**

(54) Process for producing a semiconductor device having an insulating layer of silicon dioxide covered by a film of silicon oxynitride.

(30) Priority: **14.06.78 JP 71618/78**
**15.06.78 JP 72654/78**

(43) Date of publication of application:
**23.02.83 Bulletin 83/08**

(45) Publication of the grant of the patent:
**01.10.86 Bulletin 86/40**

(84) Designated Contracting States:
**DE GB NL**

(56) References cited:
**DE-A-1 644 012**
**FR-A-2 223 836**
**FR-A-2 313 770**
**GB-A-2 004 693**
**US-A-3 798 061**

**IBM-Technical Disclosure Bulletin, vol. 19, no. 3, Aug. 1976, p. 905**

**IBM Technical Disclosure Bulletin, vol. 17, no. 8, Jan. 1975, p. 2330**

(73) Proprietor: **FUJITSU LIMITED**
**1015, Kamikodanaka Nakahara-ku**
**Kawasaki-shi Kanagawa 211 (JP)**

(72) Inventor: **Ito, Takashi**
**408 Noborito Tama-ku**
**Kawasaki-shi Kanagawa 214 (JP)**
Inventor: **Nozaki, Takao**
**22-9 Chigusadai Midori-ku**
**Yokohama-shi Kanagawa 227 (JP)**

(74) Representative: **Lawrence, Peter Robin**
**Broughton et al**
**GILL JENNINGS & EVERY 53-64 Chancery Lane**
**London WC2A 1HN (GB)**

(56) References cited:
**J. of the Electrochemical Society, vol. 123, no. 7, July 1976, pages 1117-1120 E.KOOI et al." Formation of silicon nitride at a Si-Sio2 interface during local oxidation of silicon and during heat-treatment of oxidized silicon in NH3 gas.**

## Description

The present invention relates to a process for producing a semiconductor device, having an insulating film comprising a film of silicon dioxide covered by a film of silicon oxynitride, comprising the steps of forming an exposed film of silicon dioxide over a silicon substrate and then nitriding the exposed surface of the silicon dioxide by heating in a nitriding atmosphere. Such a process is known from IBM-Technical Disclosure Bulletin, Vol. 19, No. 3, Aug. 1976, p.905.

Materials that have been used as insulating films in silicon semiconductor devices in the past include silicon dioxide ($SiO_2$), silicon nitride ($Si_3N_4$) and silicon oxynitride ($SiO_xN_y$). Silicon dioxide is usually formed by a thermal oxidation of the silicon substrate or CVD or controlled vapour deposition process and thus, is inherently not dense. Silicon nitride has always been formed by CVD (chemical vapor deposition) process or by directly nitridating silicon. Silicon oxynitride has been formed by a CVD process using $NH_3$, $O_2$ and $SiH_4$ gases.

It is also known to use a double film, wherein alumina ($Al_2O_3$), silicon nitride or a mixture of $Al_2O_3$ and $Si_3N_4$ is applied or laminated on a silicon dioxide film. The known insulating single or double film is, however, unstable during the production or operation of the semiconductor device, and does not have a dense structure. Furthermore, it is inevitable that an interface is caused between the insulating film and the silicon substrate when it is applied by the CVD process.

In a further known CVD process for producing silicon oxynitride, monosilane ($SiH_4$), ammonia ($NH_3$) and oxygen ($O_2$) are brought into reaction with each other at a temperature of, for example, 700°C, see also FR—A—2,223,836. The molar ratio of ammonia with respect to oxygen may be varied or changed gradually during the CVD period. However, the silicon oxynitride produced by this CVD process possesses structural defects. The inventors of the present invention believe that the structural defects are caused by the fact that intermediate reaction products of the CVD reaction are incorporated into the insulation film.

A further disadvantage of the CVD process mentioned above is that it is difficult precisely to adjust the thickness of the silicon oxynitride film, and to form a film having a thickness of 10 µm or less.

It is well known in the field of semiconductor devices to use silicon dioxide ($SiO_2$) as an insulating film on a semiconductor silicon substrate. Since the semiconductor device is required to operate both reliably and stably for a long period of time, contamination of the semiconductor substrate surface, which is believed to be the major reason for deterioration in its reliability, is prevented by covering the surface of the semiconductor substrate with a silicon dioxide film. Silicon dioxide is the insulating material which is most frequently used for such covering, namely for surface passivation.

It is also known that a single film of silicon dioxide cannot effectively prevent the surface of the semiconductor substrate from being contaminated by contaminants, such as moisture or sodium ions, from outside the semiconductor device. Accordingly, an upper film of alumina ($Al_2O_3$) is sometimes applied on the film of silicon dioxide. Instead of the alumina film, a phosphorus glass layer, a boron glass layer or a lead glass layer may be formed on the silicon dioxide film. The formation of the phosphorus glass layer or phosphorus treatment can be simply carried out and effectively passivates the semiconductor surface. Although the phosphorus treatment is most frequently used in the industrial production of semiconductor devices, the surface of the passivation film, on which the phosphorus is impregnated, is hygroscopic and, hence unstable.

It is also known that the silicon dioxide film, which can be formed by directly oxidising the silicon substrate, is superior to an insulating film directly, deposited on the silicon substrate by the CVD process. This is because the CVD process involves a contamination of the interface between the film and substrate due to vapour sources.

It is, therefore, an object of the present invention to provide a dense insulating film for semiconductor devices which does not have the disadvantages of the conventional insulating films.

A process according to the invention for producing a semiconductor device, having an insulating film comprising a film of silicon dioxide covered by a film of silicon oxynitride, comprises the steps of forming an exposed film of silicon dioxide over a silicon substrate and then nitriding the exposed surface of the silicon dioxide by heating in a nitriding atmosphere characterised in that the nitriding atmosphere contains ionized nitrogen atoms in a plasma state and the heating temperature of the silicon dioxide film is in the range from 800 to 1300°C.

The insulating film so formed according to this invention comprises a so called silicon oxynitride, which is a silicon dioxide in which oxygen atoms are replaced, although not stoichiometrically, by nitrogen atoms. The silicon oxynitride formed by the present invention is distinguished from the known silicon oxynitride, formed by a CVD process using $NH_3$, $SiH_4$ and $O_2$ gases since a film of silicon dioxide is subjected to a nitridating step in accordance with the present invention. The silicon oxynitride film produced according to the present invention is also distinguished from the known, double structure film of a lower, silicon dioxide layer and an upper, silicon nitride layer, because in the known structure, the silicon nitride layer is deposited on the silicon dioxide layer whilst in the present invention the silicon dioxide layer is partly nitrided or impregnated with nitrogen. Accordingly, the insulating film made in accordance with the present invention does not have the disadvantages, such as the formation of structural defects therein and contamination of the interface between such a film and the semiconductor silicon substrate.

It is known to form a silicon dioxide film by thermal oxidation of a semiconductor silicon substrate. This comprises the step of heating the substrate to an elevated temperature of from 600 to 1200°C in an oxidising atmosphere of, for example, oxygen or water. Depending on the purpose of the silicon dioxide film, the thickness of the film is selected to be in the range of from 3 to 2000 nm.

The thermal oxidation of silicon is suitable for preventing the increase of electric charges on the surface of the silicon substrate to a level of more than $10^{12}$ cm$^{-2}$.

The nitridation process of silicon dioxide film according to the present invention comprises a step of heating the semiconductor silicon substrate and the silicon dioxide film formed on the substrate to a temperature of from 800 to 1300°C, preferably from 1000 to 1200°C in a nitridating atmosphere containing ionised nitrogen atoms in a plasma state. Since experiments by the inventors have shown that no silicon oxynitride was formed by the heat treatment using molecular nitrogen gas, it is essential to use ionised nitrogen in the form of a plasma for the nitridation atmosphere.

Particular embodiments of the present invention may comprise the steps of forming a film consisting essentially of a silicon nitride on a silicon substrate, by subjecting the substrate to a direct thermal nitridation, oxidising a portion of the nitride film and subsequently heating the silicon substrate in a nitriding atmosphere containing ionized nitrogen atoms in a plasma state to convert at least a portion of the oxidised surface to silicon oxynitride.

The process for forming a direct thermal nitride film of silicon may comprise a step of heating the silicon substrate in a nitrogen containing atmosphere to a temperature of from 900 to 1300°C, preferably from 1000 to 1200°C for a period of from 0.01 to 100 hours. The nitriding atmosphere may comprise a nitrogen compound, such as ammonia or hydrazine ($N_2H_4$). The nitrogen compound is preferably ammonia. The direct thermal nitride film of silicon preferably has thickness of from 2 to 10 nm, more preferably from 3 to 5 nm. Such a nitride film can be formed by using a nitridation atmosphere in which oxidant impurities, such as oxygen, water, carbon dioxide, etc., are reduced to a level of less than 100 ppm and by adjusting the nitridation temperature to a range of from 1200 to 1300°C.

It is preferable to completely clean the silicon substrate prior to the nitridation, by degreasing the silicon substrate in an organic solvent, boiling in an acid solution, preferably sulfuric and nitric acid, and etching in hydrofluoric acid. Prior to forming the direct thermal nitride film of silicon, it is preferable to heat the silicon substrate in an inert gas atmosphere at temperature of from 900 to 1300°C.

The oxidation step may comprise heating the semiconductor silicon substrate provided with the nitride film to a temperature of from 500 to 1300°C, preferably from 900 to 1200°C, in an oxidizing atmosphere of oxygen or water. The film consisting essentially of silicon nitride is gradually changed to silicon oxide by oxygen atoms, which diffuse from the surface to the interior of the film. Silicon oxide or silicon oxynitride is, therefore, formed on the oxidized surface of the film. In the oxidation step mentioned above, the thickness of the oxidized, silicon nitride film is increased because the oxide film grows to a thickness of from 3 to 19 nm, preferably from 5 to 9 nm. The total thickness of the silicon nitride and the oxidized film is increased from the thickness of the nitride film directly after the thermal nitridation of silicon.

The final nitridation step of the oxidized surface of the nitride film for the formation of silicon oxynitride is carried out as stated above.

The nitridation process of a thermal oxidation film of silicon comprises a step of heating the semiconductor silicon substrate and the silicon dioxide film formed thereon to an elevated temperature in an atmosphere of plasma gas which contains ionized nitrogen atoms. The plasma gas atmosphere can be generated from a nitrogen-containing gas or gases. Such gas is, preferably, ammonium, or nitrogen. The nitrogen-containing gas can be mixed with hydrogen, hydrogen chloride or chlorine gases. The plasma gas may be generated by heating the source gas under a reduced pressure of from 0.0133 to 13.3 mbar by means of an electric discharge. The electric charge is induced in a space in which the source gas is confined, by applying a high frequency current of from 50 to 1000 KHz and a voltage of from 1 KV to 100 KV. The nitridation process using the plasma gas is advantageous because various kinds of gases can be used and, further, the heating temperature is low, i.e., in the range of from 800 to 1300°C, preferably from 800 to 1100°C. The nitridation time using the plasma gas is reduced compared to that when using non plasma gases.

The insulation film comprising the silicon oxynitride produced according to the present invention are not liable to contamination by impurities, such as moisture, and sodium and potassium ions. The surface state density ($N_{ss}$) of the insulation film is decreased considerably the nitridation of silicon dioxide to a level of approximately $5 \times 10^{11}$ to $1 \times 10^{10}$/cm$^2$ at a silicon surface potential of 0.3eV. It is believed by the Inventors that, because of a decrease in the drift of sodium ions due to the nitridation, the behaviour of the capacitance change depending upon the voltage applied to the insulation film is decisively influenced by injection of cariers into a trap level, which is present in the proximity of the interface between the silicon substrate and the insulation film comprising the silicon dioxide.

In the nitridation by the plasma gas it is preferable to select the heating time in the range of from 1 to 5 hours and the heating temperature in the range of from 1000 to 1200°C, so as to provide the insulation film with a low $N_{ss}$.

Under a high electric potential, the insulation films produced according to the present invention do not exhibit such disadvantageous behaviors as the movement of ions and the capturing phenomena of carriers in the film.

The insulation film comprising the silicon oxynitride produced according to the present invention, may have a high relative dielectric constant ranging from 4 to 5.3. Furthermore, the insulation films produced according to the present invention may have a high breakdown voltage in the range from from 11 to 12 MV/cm. The breakdown voltage is increased as the nitridation time increases.

The silicon oxynitride film is highly resistant against etching solutions used in the production of semiconductor devices, such as hydrofluoric acid, amomnium floric acid and their mixed solution. The resistance against etching solution is increased with an increase in the nitridation time.

The insulative film, which is formed by a nitridation of the thermally oxidized silicon substrate, has such a structure that this oxidation film is gradually converted to silicon oxynitride from the surface to the interior of this film. In other words, at least an upper surface of the insulative film comprises a silicon oxynitride, and the nitrogen content of the silicon oxynitride is gradually decreased from the surface to the interior thereof. Accordingly the insulative film produced according to the present invention is dense and includes no structural defects, which are liable to form at the interface of the laminated structure of two different kinds of layers.

The insulative film, which is formed by successive direct thermal nitridation, oxidation and the final nitridation steps according to a particular embodiment of the invention, may have a structure different from that described above, but it is dense and includes no structural defects.

The molar ratio of nitrogen to oxygen in the silicon oxynitride generally ranges from 1:10 to 10:1.

The insulative films produced according to the present invention present no such inconveniences as: contamination of the interface between the semiconductor substrate and the film due to the formation of the film, and polarization of carriers in the films caused by the electric filed. Property variation of the insulative films due to movable ions is favourably suppressed by the nitridation of the silicon dioxide.

Because of the facts mentioned above, the insulative films produced according to an embodiment of the present invention are suitable for as a passivation film of a semiconductor device. The passivation film should have a thickness of from approximately 100 to 2000 nm, preferably from 300 to 1000 nm. The thermal oxidation film of the silicon substrate to be subjected to the nitridation should have a thickness of from approximately 5 to 2000 nm, preferably from 10 to 1000 nm. The nitridation time of the silicon dioxide film should be from approximately 1 to 600 minutes in plasma and non plasma atmospheres.

When a dense insulating film in the range of from approximately 3 to 18 nm is desired for one of the mentioned uses, the direct thermal nitridation of the substrate, thermal oxidation of the silicon nitride and final nitridation of the silicon oxide should be performed successively. The direct thermal nitridation should be performed in such a manner that the nitride film grows to a thickness of from approximately 2 to 10 nm, preferably from 3 to 7 nm. The thermal oxidation time should be from approximately 0.01 to 100 hours, preferably from 0.1 to 10 hours. The nitridation after the thermal oxidation step should be carried out from approximately 0.01 to 100 hours, preferably from 0.1 to 10 hours.

Since an electrode or wiring, etc., are usually formed on the top surface of the semiconductor devices, not the thermal oxidation film of the silicon substrate but a silicon dioxide film, which is deposited on such top surface by a CVD, sputtering or vacuum evaporation process, may be subjected to the nitridation, and is used for the passivation film. The passivation films produced according to an embodiment of the present invention are highly resistant to contamination from the exterior of the semiconductor device, and enable long and stable operation of the semiconductor devices, with constant performance, even at high temperature.

The insulative films produced according to an embodiment of the present invention are also suitable for use as a gate insulation film of an MISFET. The gate insulation film should have a thickness of from approximately 3 to 300 nm, preferably from 5 to 100 nm. The thermal oxidation film of the silicon substrate to be subjected to the nitridation should have a thickness of from approximately 3 to 300 nm, preferably from 10 to 100 nm. The nitridation time of the silicon dioxide film should be from approximately 0.01 to 100 hours.

The gate insulation film produced according to an embodiment of the present invention is highly resistant to contamination from the exterior of the semiconductor device. At least one MISFET of a semiconductor device has insulative films, which are formed according to an embodiment of the present invention, and operates stably over a long period of time because of the excellent properties of the insulative films. In addition, the variation of the threshold voltage of the MISFETS is considerably lower during the operation thereof than that of the MISFETS having a conventional gate insulation film. Furthermore, no problems of a decrease in mutual conductance (gm) and an increase in the surface state density ($N_{ss}$) are presented during the operation of the MISFETs.

In semiconductor devices, such metals as gold, aluminium and molybdenum, are used for wiring conductors and are deposited on an insulative material such as silicon dioxide. When the conductor and the silicon dioxide are heated to an elevated temperature, a reaction between the conductor and the silicon dioxide occurs. When such reaction causes an increase in the resistance and a property deterioration of the conductor, such reaction is undesirable and should be presented. Using insulative films produced according to the present invention, the disadvantages mentioned above can be eliminated when heating the conductor and insulative material at a temperature ranging from 100 to 1200°C.

The insulative films for the gate insulation film and the underlying film of the conductor should have a thickness of from approximately 3 to 2000 nm, preferably from 10 to 1000 nm. The silicon oxide film to be subjected to the nitridation should have a thickness of from approximately 3 to 2000 nm, preferably from 10 to 1000 nm. The nitridation time of the silicon dioxide film should be from approximately 1 to 1000 minutes.

The insulative films produced according to the present invention are also suitable for use as a mask against selective diffusion of impurities into a semiconductor silicon substrate.

The diffusion mask should have a thickness of from approximately 5 to 1000 nm, preferably from 10 to 500 nm. The thermal oxidation film of the silicon substrate to be subjected to the nitridation should have a thickness of from approximately 5 to 1000 nm, preferably from 10 to 500 nm. The nitridation time of the silicon dioxide film should be from approximately 1 to 1000 minutes.

By means of the diffusion mask produced according to an embodiment of the present invention, the selective diffusion can be carried out by using a very thin mask, with the result that the mask does not cause any thermal stress on the silicon substrate during the diffusion step. Side diffusion does not occur due to the excellent adherence between the thermal oxidation $SiO_2$ layer of the diffusion mask and the silicon substrate. Accordingly, it is possible to produce fine diffused as on the silicon substrate. Furthermore, although the conventional, silicon dioxide mask cannot mask the silicon substrate against the impurity boron under a hydrogen atmosphere, no such problem as the boron diffusion through the mask occurs during the diffusion and heat treatment steps when using the diffusion mask produced according to an embodiment of the present invention. A property deterioration of the $SiO_2$ layer and a property deterioration of an interface between the $SiO_2$ layer and the silicon substrate are advantageously prevented by the diffusion mask produced according to an embodiment of the present invention.

The insulative films produced according to an embodiment of the present invention are furthermore suitable for use as the dielectric material of a capacitor of the semiconductor devices. An electrode is deposited on each of these insulative films.

The insulative material film for the capacitor should have a thickness of from approximately 3 to 1000 nm, preferably 5 to 500 nm. The thermal oxidation film of the silicon substrate to be subjected to the nitridation should have a thickness of from approximately 3 to 500 nm, preferably from 5 to 300 nm. The nitridation time of the silicon dioxide film should be from approximately 1 to 1000 minutes.

The insulative material of the capacitor produced according to an embodiment of the present invention exhibits higher dielectric constant than the dielectric constant of silicon dioxide. The relative dielectric constant of the insulative material produced according to an embodiment of the present invention is generally from 4 to 6. Since the insulative material can be made thin, it is possible to manufacture a capacitor having a high capacitance value from such insulative material. This capacitance value is approximately 30% higher than that of the conventional capacitor using a silicon dioxide as the dielectric material.

A semiconductor memory cell may include the excellent capacitor element mentioned above on the semiconductor silicon substrate. Consequently, the amount of electric charges stored in a memory cell of a semiconductor device produced according to the present invention is 30% higher than that in the case of using the conventional capacitor mentioned above. Accordingly, it is possible to read out the memory cell with a very low error rate.

It is possible to reduce the thickness of the insulating material in a capacitor to between 3 to 10 nm. Since a large electric charge can be stored in a memory cell using a thin insulating film for a capacitor element of the memory cell, the area of the memory cell can be reduced to less than that used previously.

Various examples of methods in accordance with this invention will now be described and contrasted with earlier, control examples, with reference to the accompanying drawings; in which:—

Figure 1 is a graph of the peak value of Auger analysis against time to demonstrate the depth of the nitride;

Figures 2 to 7 are cross sections through a semiconductor device at various stages during the formation of an MISFET element;

Figure 8 is a cross section through a MISFET.

### Example 1

P-type silicon substrates having a resistivity between 4 and 5 $\Omega$ cm were heated to 1000°C, for a period of 35 minutes, under an atmosphere of argon, which was bubbled through water having a temperature of 50°C. As a result of the heating, a silicon dioxide film having a thickness of approximately 50 nm was formed on the silicon substrates. Each of the substrates was then placed in a plasma-generating apparatus, into which nitrogen gas was introduced. The pressure of the chamber was reduced to $10^{-1}$ Torr and the nitrogen gas was activated to plasma by an electric charge of 6 KV with a frequency of 400 KHz. The substrates exposed to the plasma gas of nitrogen were heated to 1030°C, for a period of 5 hours at the maximum, by means of the RF power of 6 KV.

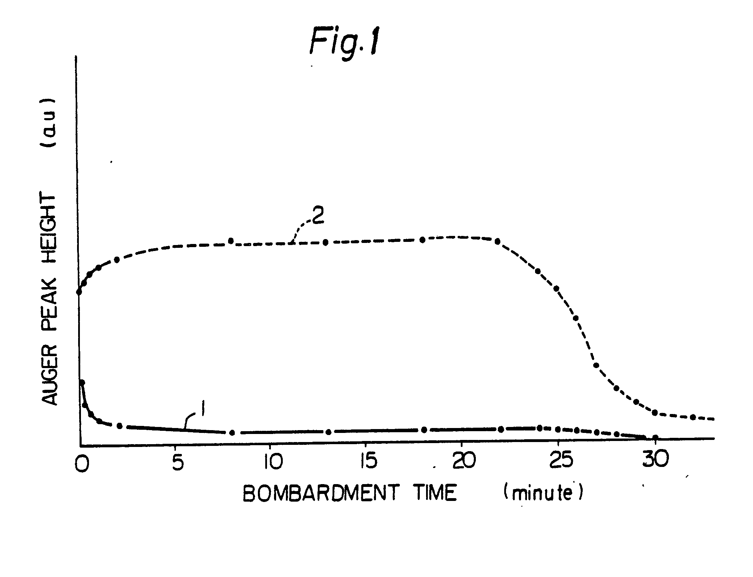

The results of the Auger analysis was as shown in Fig. 1. It will be apparent from Fig. 1, that the surface of the silicon oxide film was converted to the silicon oxynitride having a molar ratio of O/N of approximately 2.5.

The index of refraction of the insulative film on the silicon substrates was measured. The maximum index of refraction was approximately 16.5 with regard to the insulative film formed after approximately 5 hours of heating.

The thickness of the insulative film was increased by approximately 2 nm after the plasma nitridation for 5 hours.

Instead of the nitrogen gas, ammonia, a gaseous mixture of nitrogen and hydrogen, a gaseous mixture of nitrogen and hydrochloride, and a gaseous mixture of nitrogen and chlorine, were used separately for the source of the plasma gas. Essentially same results as explained above were obtained with these gases.

### Example 2

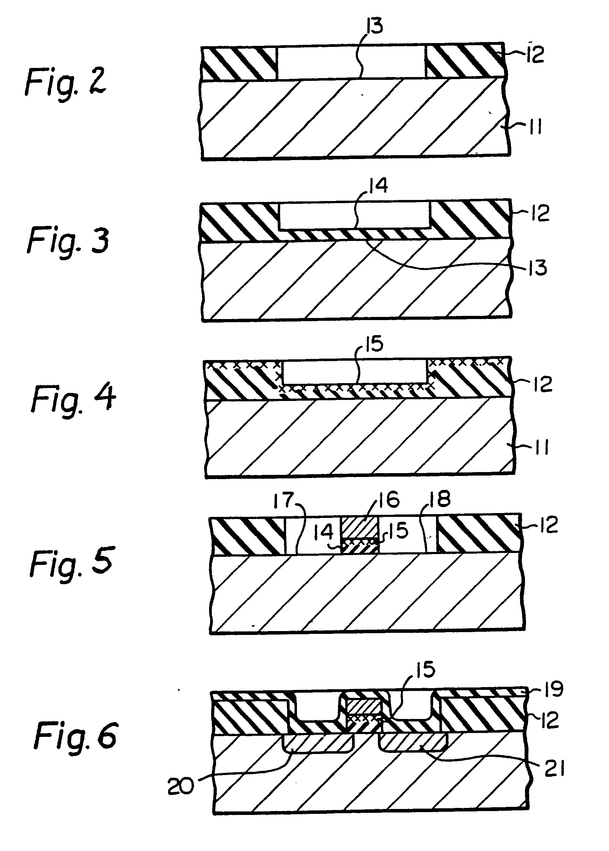

An MISFET was produced in the present Example as explained with reference to Figs. 2 through 6.

Referring to Fig. 2, silicon dioxide film 12 was formed by thermal oxidation of a P-type silicon substrate 11, having a resistivity of 1 Ω cm and including a boron dopant. A window was formed through the silicon dioxide film 12, so as to leave this film as a field insulation film. The window exposed an active region 13 of the substrate 11.

Referring to Fig. 3, the active region 13 of silicon substrate exposed through the window was subjected to a thermal oxidation similar to that explained in Example 1, and a silicon dioxide film 14, for the gate insulation film, having a thickness of 50 nm was formed. Nitridation of the silicon oxide films 12 and 14 was carried out for a period of approximately 60 minutes under the plasma nitridation condition explained in Example 1. The surface of the oxide films 12 and 14, for the field and gate insulations, respectively, which was converted to silicon oxynitride, is schematically shown in Fig. 4 by number 15 and "X" marks.

Referring to Fig. 5, a polycrystalline silicon film 16 was deposited by a CVD process on the silicon oxynitride 15 to a thickness of 300 nm and then, selectively removed to produce an electrode pattern of a gate of the MISFET. The insulative film (the original oxide film 14 and the silicon oxynitride film 15) was, therefore, partly exposed, and then, the exposed insulative film was removed by an etching solution of a buffered hydrofluoric acid. During the etching, the polycrystalline silicon film 16 masked the underlying insulative film. The etching was terminated when the silicon substrate 11 was exposed. Windows 17 and 18 for the diffusion of the source and drain of the MISFET were formed by the etching.

Referring to Fig. 6, a phospho-silicate glass (PSG) film 19, containing 5% of phosphorus, was deposited by a CVD process to a thickness of approximately 300 nm. Subsequently, the PSG film 19 was heated to 1000°C, for 30 minutes, in a nitrogen atmosphere, thereby diffusing the phosphorus from the PSG film 19 into the substrate 11. An $n^+$ type, source region 20 and drain region 21 were, therefore, formed on the diffused surface of the substrate 11.

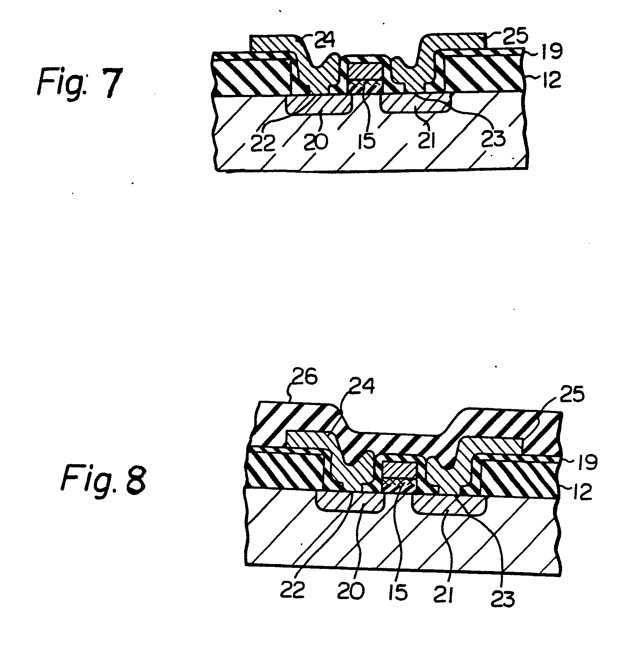

Referring to Fig. 7, the PSG film 19 was selectively removed to expose the source and drain regions 20 and 21, respectively, so that contact windows 22 and 23 of the electrodes were formed. Aluminum was deposited on the substrate and selectively removed to form the pattern of a source electrode 24 and a pattern of the drain electrode 25.

### Example 3

On the MISFET produced in Example 2, a silicon dioxide film 26 (Fig. 8) was formed by a CVD process to a thickness of 500 angstroms. The MISFET was then heated in a plasma atmosphere at 850°C, for 30 minutes. The plasma atmosphere was generated by applying an electrical discharge to a gaseous mixture of nitrogen and hydrogen in a volume ratio of 10:1. The electrical discharge was induced by applying a high frequency current of 400 KHz and 4 KV to the gaseous mixture under a pressure of 0.133 mbar. As a result of the heating under the plasma atmosphere, a silicon oxynitride layer was formed on the surface of the film 26 at a thickness of approximately 3 nm.

### Example 4 (control)

A silicon dioxide film completely free from pin holes was formed on P-type silicon substrates having a resistivity of 1 Ω cm to a thickness of 10 nm. An aluminium electrode was deposited on the silicon dioxide film. One of the substrates was heated together with silicon dioxide and aluminum electrode at 450°C, in an nitrogen ($N_2$) gas, for 30 minutes. The insulative properties of the silicon oxide film were found to have deteriorated due to the heat treatment.

A molybdenum electrode was then deposited on the silicon dioxide film of the other substrate, and a heat treatment was carried out at a temperature of 1000°C. As a result of the heat treatment molybdenum atoms were diffused into the silicon dioxide film, and a molybdenum electrode was partly oxidized by the silicon dioxide film. The deterioration of the insulative properties was more serious than in the case of the aluminum electrode.

**Claims**

1. A process for producing a semiconductor device having an insulating film comprising a film of silicon dioxide covered by a film of silicon oxynitride comprising the steps of forming an exposed film of silicon dioxide over a silicon substrate and then nitriding the exposed surface of the silicon dioxide by heating in a nitriding atmosphere characterised in that the nitriding atmosphere contains ionised nitrogen atoms in a plasma state and the heating temperature of the silicon dioxide film is in the range from 800 to 1300°C.

2. A process according to claim 1 characterised in that the nitriding atmosphere is formed by plasma activation of an atmosphere of nitrogen gas, ammonia, nitrogen and hydrogen, nitrogen and hydrochloride or nitrogen and chlorine.

3. A process according to claim 1 characterised in that the oxynitride insulating film is formed to a thickness of 3 to 19 nm.

4. A process according to any preceding claim characterised in that the exposed film of silicon dioxide is formed to be 3 to 2000 nm thick.

5. A process according to any preceding claim characterised in that the silicon dioxide film is formed by thermal oxidation of a silicon surface layer of a silicon substrate.

6. A process according to any of claims 1 to 4 characterised in that the silicon dioxide film is made by the preliminary step of forming a silicon nitride surface film by thermal nitridation of a silicon surface layer of a silicon substrate and converting the exposed surface of the silicon nitride film to silicon dioxide by oxidation.

7. A process according to claim 6 characterised in that the silicon nitride surface film is formed by heating the silicon substrate to a temperature of 900 to 1300°C in a nitrogen containing atmosphere with an oxidant impurity in an amount of less than 100 ppm and the oxidation of the exposed surface of the silicon nitride film to silicon dioxide is effected by heating the silicon nitride in an oxidising atmosphere at a temperature of 500 to 1300°C.

**Patentansprüche**

1. Verfahren zur Herstellung einer Halbleitervorrichtung, die einen isolierenden Film hat, mit einem Film aus Siliziumdioxid, der durch einen Film aus Siliziumoxinitrid gebildet ist, mit den Schritten der Bildung eines exponierten Films aus Siliziumdioxid über einem Siliziumsubstrat und anschließender Nitrierung der exponierten Oberfläche des Siliziumdioxids durch Erwärmung in einer nitrierenden Atmosphäre, dadurch gekennzeichnet, daß die nitrierende Atmosphäre ionisierte Stickstoffatome in einem Plasmazustand enthält und die Erwärmungstemperatur des Siliziumdioxids im Bereich von 800 bis 1300°C liegt.

2. Verfahren nach Anspruch 1, dadurch gekennzeichnet, daß die nitrierende Atmosphäre durch Plasmaaktivierung von einer Atmosphäre aus Stickstoffgas, Ammoniak, Stickstoff und Wasserstoff, Stickstoff und Chlorwasserstoff oder Stickstoff und Chlor besteht.

3. Verfahren nach Anspruch 1, dadurch gekennzeichnet, daß der isolierende Film aus Oxinitrid in einer Dicke von 3 bis 19 nm gebildet wird.

4. Verfahren nach einem der vorhergehenden Ansprüche, dadurch gekennzeichnet, daß der exponierte Film aus Siliziumdioxid 3 bis 2000 nm dick ist.

5. Verfahren nach einem der vorhergehenden Ansprüche, dadurch gekennzeichnet, daß der Siliziumdioxidfilm durch thermische Oxidation einer Siliziumoberflächenschicht auf einem Siliziumsubstrat gebildet wird.

6. Verfahren nach einem der Ansprüche 1 bis 4, dadurch gekennzeichnet, daß der Siliziumdioxidfilm durch den vorläufigen Schritt der Bildung eines Siliziumnitridoberflächenfilms durch ther-

mische Nitrierung einer Siliziumoberflächenschicht eines Siliziumsubstrats und durch Konvertierung der exponierten Oberfläche des Siliziumnitridfilms zu Siliziumdioxid durch Oxidieren gebildet wird.

7. Verfahren nach Anspruch 6, dadurch gekennzeichnet, daß der Siliziumnitridoberflächenfilm durch Erwärmen des Siliziumsubstrats auf eine Temperatur von 900 bis 1300°C in einer Stickstoff enthaltenden Atmosphäre mit einer oxidierenden Verunreinigung in einem Betrag von weniger als 100 ppm gebildet wird und die Oxidierung der exponierten Oberfläche des Siliziumnitridfilms zu Siliziumdioxid durch Erwärmung des Siliziumnitrid in einer oxidierenden Atmosphäre bei einer Temperatur von 500 bis 1300°C bewirkt wird.

**Revendications**

1. Procédé de fabrication d'un dispositif à semiconducteur ayant un film isolant comprenant un film de bioxyde de silicium recouvert d'un film d'oxynitrure de silicium, comprenant les étapes de formation d'un film exposé de bioxyde de silicium sur un substrat de silicium puis de nitruration de la surface exposée du bioxyde de silicium par chauffage en atmosphère nitrurante, caractérisé en ce que l'atmosphère nitrurante contient des atomes ionisés d'azote à l'état de plasma, et la température de chauffage du film de bioxyde de silicium est comprise entre 800 et 1300°C.

2. Procédé selon la revendication 1, caractérisé en ce que l'atmosphère nitrurante est formée par excitation sous forme d'un plasma d'une atmosphère d'azote gazeux, d'ammoniac, d'azote et d'hydrogène, d'azote et d'un chlorhydrate ou d'azote et de chlore.

3. Procédé selon la revendication 1, caractérisé en ce que le film isolant d'oxynitrure est formé sur une épaisseur de 3 à 19 nm.

4. Procédé selon l'une quelconque des revendications précédentes, caractérisé en ce que le film exposé de bioxyde de silicium est formé à une épaisseur comprise entre 3 et 2000 nm.

5. Procédé selon l'une quelconque des revendications précédentes, caractérisé en ce que le film de bioxyde de silicium est formé par oxydation thermique d'une couche superficielle de silicium d'un substrat de silicium.

6. Procédé selon l'une quelconque des revendications 1 à 4, caractérisé en ce que le film de bioxyde de silicium est formé par une étape préliminaire de formation d'un film superficiel de nitrure de silicium par nitruration thermique d'une couche superficielle de silicium d'un substrat de silicium, et par transformation de la surface exposée du film de nitrure de silicium en bioxyde de silicium par oxydation.

7. Procédé selon la revendication 6, caractérisé en ce que le film superficiel de nitrure de silicium est formé par chauffage du substrat de silicium à une température de 900 à 1300°C en atmosphère contenant de l'azote, avec une impureté oxydante en quantité inférieure à 100 ppm, et l'oxydation de la surface exposée du film de nitrure de silicium en bioxyde de silicium est réalisée par chauffage du nitrure de silicium en atmosphère oxydante à une température de 500 à 1300°C.

# Fig.1

1

*Fig. 2*

*Fig. 3*

*Fig. 4*

*Fig. 5*

*Fig. 6*

Fig. 7

Fig. 8